# EUROPEAN PATENT SPECIFICATION

(11) **EP 4 020 806 B1**
(45) Date of publication and mention of the grant of the patent: **20.11.2024**
(21) Application number: 21210884.9
(22) Date of filing: 26.11.2021
(51) Int. Cl.: H03K 17/0412, H03K 17/06, H03M 1/12

(54) **BOOTSTRAPPING CIRCUIT, SAMPLING APPARATUSES, RECEIVER, BASE STATION, MOBILE DEVICE AND METHOD OF OPERATING A BOOTSTRAPPING CIRCUIT**
BOOTSTRAPPING-SCHALTUNG, ABTASTVORRICHTUNGEN, EMPFÄNGER, BASISSTATION, MOBILE VORRICHTUNG UND VERFAHREN ZUM BETRIEB EINER BOOTSTRAPPING-SCHALTUNG
CIRCUIT DE BOOTSTRAPPING, APPAREILS D'ÉCHANTILLONNAGE, RÉCEPTEUR, STATION DE BASE, DISPOSITIF MOBILE ET PROCÉDÉ DE FONCTIONNEMENT D'UN CIRCUIT DE BOOTSTRAPPING

(30) Priority: 23.12.2020 US 202017131848
(43) Date of publication of application: 29.06.2022
(73) Proprietor: Intel Corporation, Santa Clara, CA 95054 (US)
(72) Inventor: LINDHOLM, Christian, 9500 Villach (AT); CASCIO, Giacomo, 9500 Villach (AT); CLARA, Martin, Santa Clara, 95050 (US); GRUBER, Daniel, 9433 St. Andrä (AT)
(74) Representative: 2SPL Patentanwälte PartG mbB

(56) References cited:
- EP-A1- 2 922 065
- WO-A1-95/32506
- US-A1- 2015 188 536
- US-A1- 2018 076 808
- US-A1- 2020 076 415
- US-A1- 2020 162 074
- US-B1- 8 525 574

## Description

### Field

The present disclosure relates to bootstrapping for semiconductor switches. In particular, examples relate to a bootstrapping circuit for a semiconductor switch, a sampling apparatus comprising the bootstrapping circuit, another sampling apparatus, a receiver comprising one of the sampling apparatuses, a base station comprising the receiver, a mobile device comprising the receiver and a method of operating a bootstrapping circuit.

### Background

Conventional bootstrappers used to linearize the input signal switch in an Analog-to-Digital Converter (ADC) load the buffer preceding the ADC. The capacitance seen at the input of the bootstrapper may be as big or even larger than the sample capacitance itself.

When turning on the switch, a large current spike is needed. Further, the buffer and the connection between the buffer and the ADC must be designed accordingly. In a differential system, the buffer voltage is a common mode voltage +/- the AC part of the input signal. Unless the common mode voltage is 0V, the buffer has to deliver a non-differential current to charge to the wanted voltage. The voltage at the ADC input must settle within the sampling period. The current spike in combination with the more or less inductive signal distribution limits the settling speed.

Document US 8 525 574 B1 proposes a bootstrap switch circuit with over-voltage prevention. The bootstrap switch circuit comprises bootstrap circuitry for switching a switch of the bootstrap switch circuit on and off. The bootstrap circuitry comprises a first capacitor which is charged before the switch is turned on. The bootstrap circuitry comprises a second capacitor injecting charge into the gate of the switch while the switch is turned on.

Document WO 95/32506 A1 proposes a constant impedance sampling switch. The circuitry comprises switch is implemented by a transistor which is bootstrapped. The circuitry further comprises a capacitor which is charged before the switch is turned on. The circuitry comprises a second capacitor injecting charge into the gate of the switch while the switch is turned on.

There may be a desire for improved bootstrapping.

A bootstrapping circuit for a semiconductor switch and a corresponding method of operating a bootstrapping circuit for a semiconductor switch are defined in independent claims 1 and 9. Further preferred embodiments are defined in the dependent claims.

### Brief description of the Figures

Some examples of apparatuses and/or methods will be described in the following by way of example only, and with reference to the accompanying figures, in which
Fig. 1 illustrates an example of a bootstrapping circuit for a semiconductor switch;
Fig. 2 illustrates a first example of charge injection circuitry;
Fig. 3 illustrates a second example of charge injection circuitry;
Fig. 4 illustrates a third example of charge injection circuitry;
Fig. 5 illustrates a first example of a sampling apparatus;
Fig. 6 illustrates a second example of a sampling apparatus;
Fig. 7 illustrates a comparison between exemplary input currents and voltages;
Fig. 8 illustrates an example of a base station;
Fig. 9 illustrates an example of a mobile device; and
Fig. 10 illustrates a flowchart of an example of a method of operating a bootstrapping circuit.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

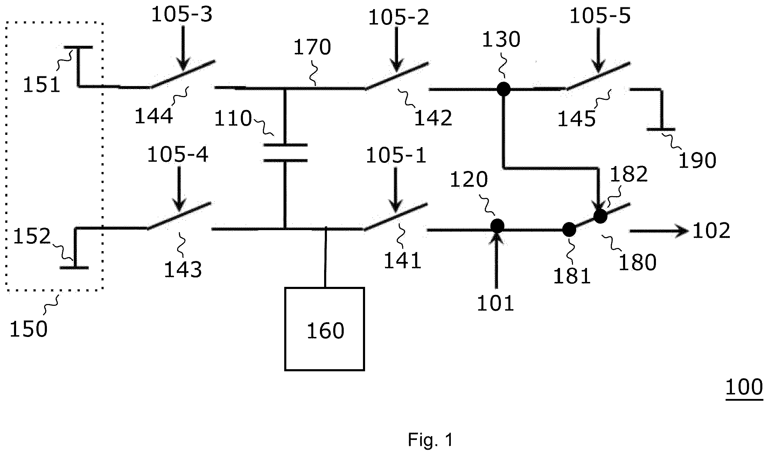

**Fig. 1** illustrates an example of a bootstrapping circuit 100 for a semiconductor switch 180.

The bootstrapping circuit 100 comprises a first node 120 for coupling to an input node 181 of the semiconductor switch 180. An input signal 101 to be sampled by the semiconductor switch 180 is received by the bootstrapping circuit 100 at the first node 120. Similarly, the semiconductor switch 180 receives the input signal 101 at the input node 181. The input signal 101 may, e.g., be an analog Radio Frequency (RF) signal.

The bootstrapping circuit 100 further comprises a second node 130 for coupling to a control node 182 of the semiconductor switch 180. The switching operation of the semiconductor switch 180 (i.e. the opening and closing of the semiconductor switch 180) is controlled by the input to the control node 182. For example, the control node 182 may be a gate node or be coupled to one or more gate nodes of the semiconductor switch 180.

The bootstrapping circuit 100 additionally comprises a capacitor 110.

Further, the bootstrapping circuit 100 comprises a switch circuit configured to selectively couple the capacitor 110 to a charge source 150 while the semiconductor switch 180 is open (i.e. in a non-conductive state), i.e. while the semiconductor switch 180 is kept open by the bootstrapping circuit 100. In the example of Fig. 1, the switch circuit of the bootstrapping circuit 100 comprises switches 143 and 144 for coupling the capacitor 110 to the charge source 150. As illustrated in Fig. 1, the charge source 150 may comprise a third node 151 configured to receive a first voltage supply signal (e.g. a positive supply voltage V_{DD}) and a fourth node 152 configured to receive a second voltage supply signal (e.g. a negative supply voltage Vₛₛ or ground). However, it is to be noted that charge source 150 may also be implemented different. Accordingly, the switch 143 selectively couples the capacitor 110 to the third node 151 and the switch 144 selectively couples the capacitor 110 to the fourth node 152 such that the capacitor 110 is charged by the potential difference between the nodes 151 and 152 while the semiconductor switch 180 is open. In other words, the capacitor 110 is pre-charged while the semiconductor switch 180 is open.

The switch circuit is further configured to selectively close a conductive path 170 between the first node 120 and the second node 130 for closing the semiconductor switch 180. The conductive path 170 includes the capacitor 110. In the example of Fig. 1, the switch circuit of the bootstrapping circuit 100 comprises switches 141 and 142 for selectively closing the conductive path 170. The switch 141 is coupled between the capacitor 110 and the first node 120. The switch 142 is coupled between the capacitor 110 and the second node 130. When the switches 141 and 142 are closed, the conductive path 170 along the capacitor 110 is closed such that the voltage at the second node 130 is equal to the sum of the voltage of the input signal 101 and the voltage generated by the pre-charged capacitor 110.

When turning on the semiconductor switch 180 by closing the switches 141 and 142, a (large) current spike is needed to charge the parasitic capacitances of the bootstrapping circuit 100. The current spike is conventionally drawn from preceding circuitry that supplies the input signal 101 to the first node 110 of the bootstrapping circuit 100 and the input node 181 of the semiconductor switch 180. As a consequence, the preceding circuitry and the signal line(s) connecting the preceding circuitry with the bootstrapping circuit 100 and the semiconductor switch 180 should be designed accordingly. The preceding circuitry may, e.g., be a buffer. For example, in a differential system, the buffer voltage may be some common mode voltage +/- the AC part of the input signal 101. Unless the common mode voltage is 0V, the buffer has to deliver a non-differential current to charge to the wanted voltage.

Further, the voltage at the input node 181 of the semiconductor switch 180 (i.e. the input signal 101) needs to settle within a sampling period of the semiconductor switch 180. Accordingly, the drawn current spike in combination with an, e.g., more or less inductive signal distribution may limit the settling speed and, hence, the sampling speed of the semiconductor switch 180.

In order to reduce the current drawn from the preceding circuitry, the bootstrapping circuit 100 comprises charge injection circuitry 160. The charge injection circuitry 160 is configured to inject additional charge into the conductive path 170 before, while or after the conductive path 170 is closed by the switch circuit. In other words, the charge injection circuitry 160 injects further charge into the conductive path 170 in addition to the charge already stored in the pre-charged capacitor 110. The additional charge injected by the charge injection circuitry 160 allows to charge the parasitic capacitances of the bootstrapping circuit 100 such that less current needs to be drawn from the preceding circuitry (e.g. a buffer).

Accordingly, the voltage at the input node 181 of the semiconductor switch 180 (i.e. the input signal 101) can settle faster such that the sampling speed of the semiconductor switch 180 may be increased compared to conventional approaches. Further, the specifications for the preceding circuitry and the signal line(s) connecting the preceding circuitry with the bootstrapping circuit 100 and semiconductor switch 180 may be more relaxed as the drawn current is lower. For example, the achieved decrease of drawn current may allow to reduce the current capability of a preceding buffer as well as its power supply.

In other words, an aspect of the present disclosure is to reduce the current drawn from the preceding circuitry such as a buffer (i.e. the current that flows through the switch 141) by injecting charge. For example, the charge may be injected like a "pre-charging" when the semiconductor switch 180 is closing or just before the semiconductor switch 180 is closing, or after the semiconductor switch 180 is closing. The semiconductor switch 180 outputs a sampled signal 102.

Although Fig. 1 illustrates that the charge injection circuitry 160 is configured to inject charge into the conductive path 170 at a node between the capacitor 110 and the switch 141, it is to be noted that the charge injection circuitry 160 according to the claimed invention is configured to inject charge into the conductive path 170 at the node 120.

The switch circuit by means of the switches 143 and 144 is further configured to decouple the capacitor 110 from the charge source 150 before the conductive path 170 is closed by the switch circuit (here the switches 141 and 142).

The switch circuit by means of the switches 141 and 142 is further configured to decouple the capacitor 110 from the first node 120 and the second node 130 while the capacitor is coupled to the charge source 150 by the switch circuit (here the switches 143 and 144).

The switch circuit is further configured to selectively couple the second node 130 to a fifth node 190 for opening the semiconductor switch 180 and keeping the semiconductor switch 180 open (i.e. in a non-conductive state). The fifth node 190 is configured to receive a reference voltage signal (e.g. the negative supply voltage Vₛₛ or ground). In the example of Fig. 1, the switch circuit of the bootstrapping circuit 100 comprises a switch 145 for selectively coupling the second node 130 to the fifth node 190. The switch circuit by means of the switch 145 is further configured to decouple the second node 130 from the fifth node 190 when/while closing the semiconductor switch 180.

The switches 141, ..., 145 of the switch circuit may be implemented as semiconductor switches (e.g. Metal-Oxide-Semiconductor, MOS, switches). The opening and closing of the switches 141, ..., 145 is controlled by means of a respective control signal 105-1, ..., 105-5. The control signals 105-1, ..., 105-5 may be provided by control circuitry for controlling the sampling operation of the semiconductor switch 180.

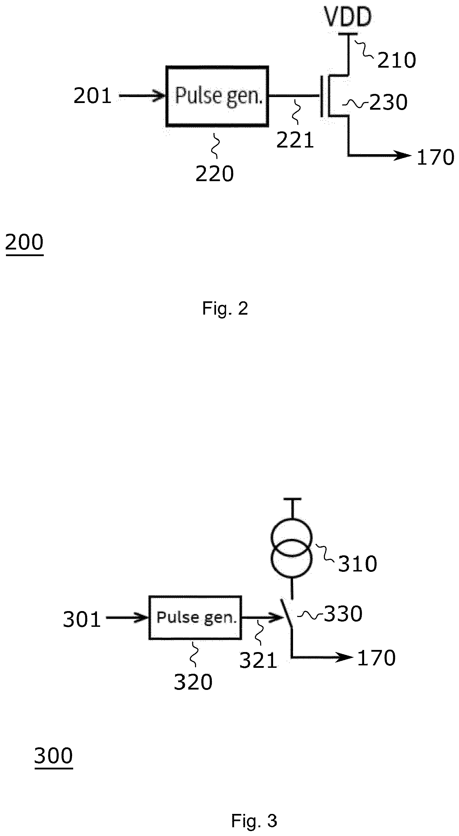

The charge injection circuitry 160 may be implemented in various ways. In the following, three exemplary implementations will be described with reference to Figs. 2 to 4. However, it is to be noted that the present disclosure is not limited thereto. Also other implementations of the charge injection circuitry 160 may in general be used.

Fig. 2 illustrates exemplary charge injection circuitry 200. The charge injection circuitry 200 comprises a node 210 configured to receive the first voltage supply signal (e.g. the positive supply voltage V_{DD}).

Additionally, the charge injection circuitry 200 comprises a pulse generator 220 configured to selectively generate a pulse 221 based on a control signal 201. The charge injection circuitry 200 comprises a switch 230 configured to selectively couple the sixth node 210 with the conductive path 170 upon reception of the pulse 221. In the example of Fig. 2, the switch 230 is implemented by a transistor. In general, the switch 230 may be any type of switch, e.g., a semiconductor switch. The switch 230 couples the sixth node 210 to the conductive path 170 for the duration (length) of the pulse 221. Accordingly, a (e.g. short) current pulse is injected into the conductive path 170 for charging the parasitic capacitances in the conductive path 170. The duration (length) of the pulse 221 may be selected based on the, e.g., estimated parasitic capacitances in the bootstrapping circuit 100.

The control signal 201 may be identical to or be derived from another control signal received by the switch circuit of the bootstrapping circuit 100 for controlling the selective closure of the conductive path 170. For example, the control signal 201 may be identical to or be derived from the control signal 105-1 for the switch 141.

In other words, the pulse generator 220 is used to close the switch from the conductive path 170 to the first voltage supply signal for a short time so that the voltage in the conductive path 170 is quickly charged to a voltage which is close to, e.g., the common mode voltage of the circuitry preceding the bootstrapping circuit 100 (e.g. a buffer). The pulse generator 220 connected to the (e.g. an NMOS or PMOS) switch 230 may allow to implement a current pulse for (e.g. pre-) charging the capacitor 110 of the bootstrapping circuit 100.

The first voltage supply signal may be provided by a local power supply. Using the local power supply may be advantageous in that the current loop is reduced since local decoupling capacitors (e.g. only a couple µm away) may deliver the current instead of circuitry preceding the bootstrapping circuit 100 (e.g. a buffer), which may be about 100µm distant.

**Fig. 3** illustrates another exemplary charge injection circuitry 300 which uses a current source 310 instead of the voltage source. The current source 310 is configured to generate a current signal. Similarly to what is described above for the pulse generator 220, the pulse generator 320 of the charge injection circuitry 300 is configured to selectively generate a pulse 321 based on a control signal 301. The control signal 301 may be identical to or be derived from another control signal received by the switch circuit of the bootstrapping circuit 100 for controlling the selective closure of the conductive path 170 (e.g. the control signal 105-1 for the switch 141).

A switch 330 of the charge injection circuitry 300 is configured to selectively couple the current source 310 with the conductive path 170 upon reception of the pulse 321. In the example of Fig. 3, the switch 330 is implemented by a transistor. In general, the switch 330 may be any type of switch, e.g., a semiconductor switch. The switch 330 couples the current source 310 to the conductive path 170 for the duration (length) of the pulse 321. Accordingly, a (e.g. short) current pulse is injected into the conductive path 170 for charging the parasitic capacitances in the conductive path 170.

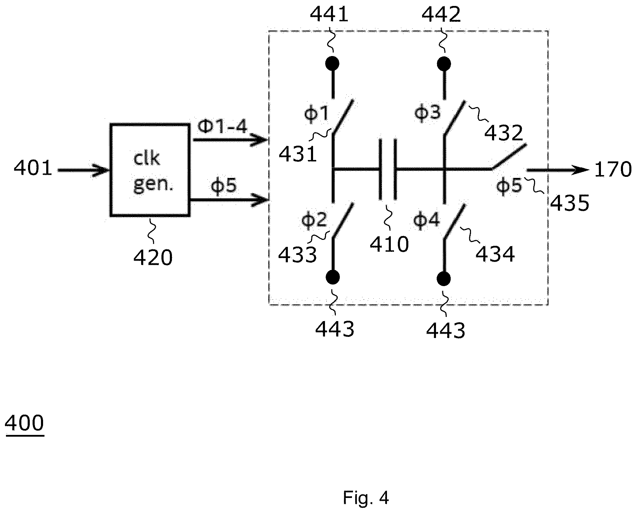

Another exemplary charge injection circuitry 400 based on a switched capacitor is illustrated in **Fig. 4****.** The charge injection circuitry 400 comprises a buffer capacitor 410 and switches 431, 432, 433, 434 and 435. The switches 431 and 432 allow to couple the buffer capacitor 410 to nodes 441 and 442 that receive the first voltage supply signal. The switches 433 and 434 allow to couple the buffer capacitor 410 to nodes 443 and 444 that receive the second voltage supply signal. The switch 435 allows to couple the buffer capacitor 410 to the conductive path 170.

Further, the charge injection circuitry 400 comprises a control circuit 420 configured to control the switches 431, 432, 433, 434 and 435 by means of the signals Φ1, ..., Φ5. In particular, the control circuit 420 configured to control, based on a control signal 401, the switches 431, 432, 433, 434 to selectively couple the buffer capacitor 410 to or more of the nodes 441, ... 444 for charging the buffer capacitor 410. The control circuit 420 controls the switch 435 to selectively decouple the buffer capacitor 410 from the conductive path 170 while charging the buffer capacitor 410.

The control circuit 420 is further configured to control, based on the control signal 401, the switch 435 to selectively couple the buffer capacitor 410 to the conductive path 170. The control circuit 420 controls the switches 431, 432, 433, 434 to selectively decouple the buffer capacitor 410 from the nodes 441, ... 444 while the buffer capacitor 410 is coupled to the conductive path 170.

The control signal 401 may be identical to or be derived from another control signal received by the switch circuit of the bootstrapping circuit 100 for controlling the selective closure of the conductive path 170 (e.g. the control signal 105-1 for the switch 141).

In other examples, the charge injection circuitry 400 may comprise more than the one buffer capacitor 410 illustrated in Fig. 4. Further, the charge injection circuitry 400 may comprise more or less switches than in illustrated in Fig. 4 for selectively coupling the one or more buffer capacitors to nodes receiving a respective one of the first voltage supply signal and the second voltage supply signal. Similarly, the charge injection circuitry 400 may comprise more switches for selectively coupling the one or more buffer capacitors to the coupling path.

The charge injection circuitry 400 is flexible and can deliver charge in both directions, which may be beneficial if one wants to push charge into and out of the conductive path 170.

In general, the switching circuitry 400 may comprise one or more buffer capacitors and a plurality of switches. The control circuit 420 may, in general, be configured to control, based on the control signal 401, the plurality of switches to selectively couple one or more of the one or more buffer capacitors to nodes configured to receive a respective one of the first voltage supply signal and the second voltage supply signal for charging one or more of the one or more buffer capacitors. The control circuit 420 may, in general, further be configured to control, based on the control signal 401, the plurality of switches to selectively couple one or more of the one or more buffer capacitors to the conductive path 170.

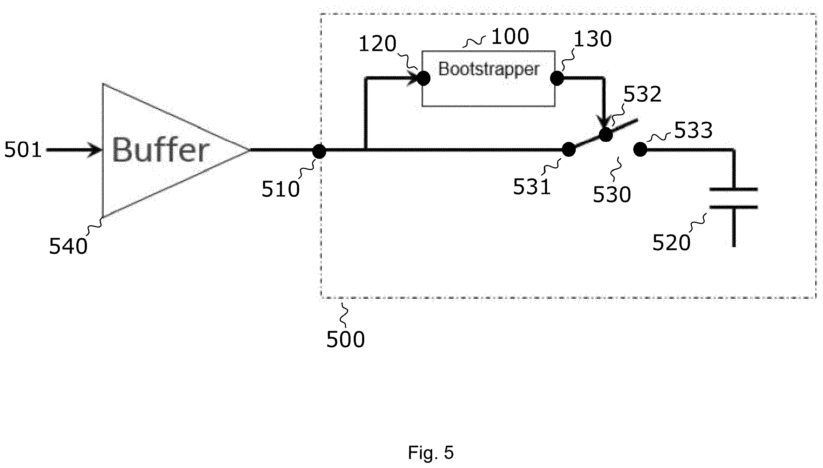

Fig. 5 illustrates an example of a sampling apparatus 500 that uses a bootstrapping circuit according to the present disclosure.

The sampling apparatus 500 comprises an input node 510 configured to receive an input signal 501 from a buffer 540. Further, the sampling apparatus 500 comprises a sampling capacitor 520.

A semiconductor switch 530 of the sampling apparatus 500 is coupled between the input node 510 and the sampling capacitor 520. The semiconductor switch 530 is configured to selectively couple the sampling capacitor 520 to the input node 510 for sampling the input signal 501. In particular, an input node 531 of the semiconductor switch 530 is coupled to the input node 510 of the sampling apparatus 500 for receiving the input signal 501. Further, an output node 533 of the sampling switch 530 is coupled to the sampling capacitor 520.

The operation of the semiconductor switch 530 is controlled by a bootstrapping circuit 100 according to one or more aspects of the architecture described above in connection with Figs. 1 to 4 or one or more examples described above in connection with Figs. 1 to 4. The first node 120 of the bootstrapping circuit 100 is coupled to the input node 510 of the sampling apparatus 500 and the input node 531 of the semiconductor switch 530 such that the bootstrapping circuit 100 receives the input signal 501. The second node 120 of the bootstrapping circuit 100 is coupled to a control node 532 of the semiconductor switch 530.

By selectively closing the coupling path within the bootstrapping circuit 100 as described above, the semiconductor switch 530 may be selectively closed by the bootstrapping circuit 100 in order to sample the input signal 501. Similar to what is described above, the additional charge injected by the charge injection circuitry of the bootstrapping circuit 100 may allow to charge the parasitic capacitances of the bootstrapping circuit 100 such that a smaller current peak is drawn from the buffer 540. Accordingly, the input signal 501 may settle faster at the input node 531 of the semiconductor switch 530 such that the sampling speed of the semiconductor switch 530 may be increased compared to conventional approaches. Further, the specifications for the buffer 540 and the signal line(s) connecting the buffer 540 with the bootstrapping circuit 100 and the semiconductor switch 530 may be more relaxed as the drawn current is lower. For example, the achieved decrease of drawn current may allow to reduce the current capability of the buffer 540 as well as its power supply.

The sampling apparatus 500 may, e.g., be an ADC that is configured to generate a digital output signal based on a charge state of the sampling capacitor 520 according to generally known techniques.

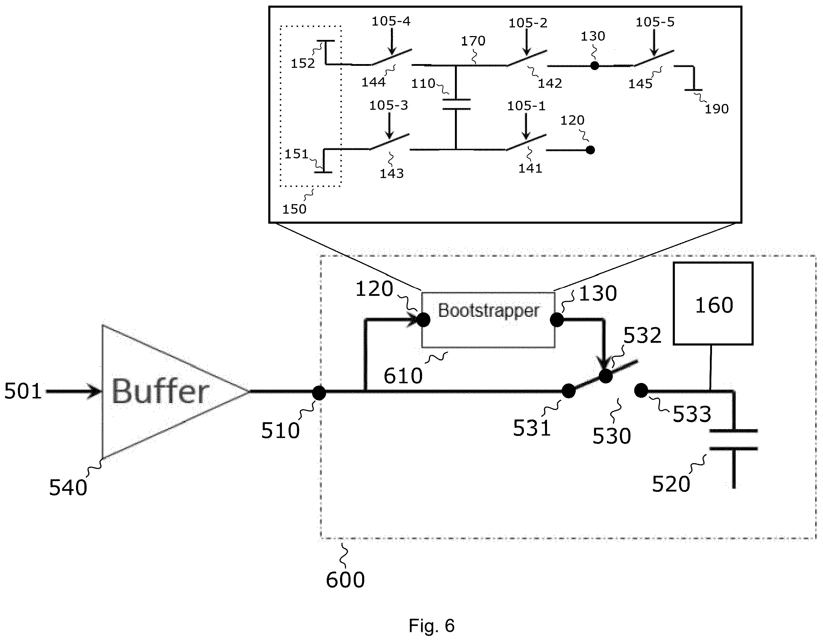

**Fig. 6** illustrates another sampling apparatus 600 which is a slightly modified compared to the above described sampling apparatus 500. In the sampling apparatus 600, a bootstrapping circuit 610 is used instead of the bootstrapping circuit 100. The bootstrapping circuit 610 differs from the bootstrapping circuit 100 in that the charging injection circuitry 160 is removed from the bootstrapping circuit 610 as the charging injection circuitry 160 is coupled to the output node 533 of the semiconductor switch 530. In the example of Fig. 6, the charge injection circuitry 160 is configured to inject charge into the output node 533 of the semiconductor switch 530 before, while or after the conductive path 170 is selectively closed by the switch circuit of the bootstrapping circuit 610.

Injecting the additional charge into the output node 533 of the semiconductor switch 530 is an alternative to injecting the additional charge into the conductive path 170 itself. Once the bootstrapping circuit 610 closes the semiconductor switch 530, the additional charge at the output node 533 of the semiconductor switch 530 can be drawn into the bootstrapping circuit 610 for charging the parasitic capacitances of the bootstrapping circuit 610.

Therefore, the sampling apparatus 600 may provide the same technical advantages as the above described sampling apparatus 500. Also the sampling apparatus 500 may, e.g., be an ADC that is configured to generate a digital output signal based on a charge state of the sampling capacitor 520 according to generally known techniques.

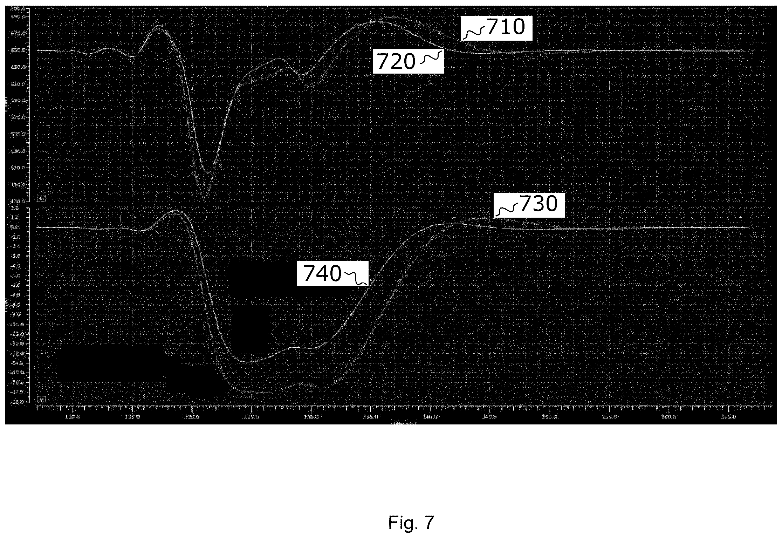

**Fig. 7** illustrates a comparison of a voltages and currents at the input node of a conventional bootstrapper and a bootstrapping circuit according to the present disclosure.

The curve 710 represents the temporal course of the voltage at the input node of the conventional bootstrapper while the semiconductor switch is closed by the bootstrapper. The curve 720 represents the temporal course of the voltage at the input node of the bootstrapping circuit according to the present disclosure (i.e. the first node 120) while the semiconductor switch is closed by the bootstrapping circuit.

The curve 730 represents the temporal course of the current at the input node of the bootstrapper while the semiconductor switch is closed by the bootstrapper. The curve 740 represents the temporal course of the current at the input node of the bootstrapping circuit according to the present disclosure (i.e. the first node 120) while the semiconductor switch is closed by the bootstrapping circuit.

As can be seen from curves 710 and 720, the voltage variation is smaller for the bootstrapping circuit according to the present disclosure compared to the conventional bootstrapper.

Similarly, as can be seen from curves 730 and 740, the current variation is smaller for the bootstrapping circuit according to the present disclosure compared to the conventional bootstrapper. Therefore, less current is drawn from preceding circuitry providing the input signal for the bootstrapping circuit and the semiconductor switch. Further, as can be seen from curves 730 and 740, the settling time is smaller for the bootstrapping circuit according to the present disclosure compared to the conventional bootstrapper. Accordingly, the semiconductor switch may be turned on faster.

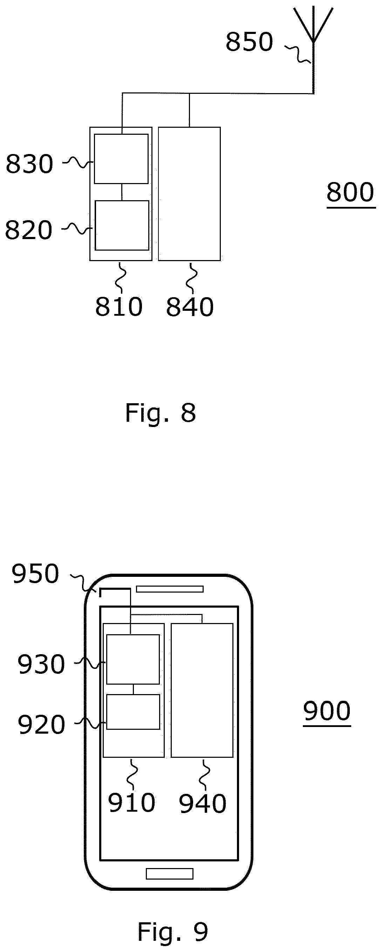

An example of an implementation using bootstrapping according to one or more aspects of the architecture described above in connection with Figs. 1 to 6 or one or more examples described above in connection with Figs. 1 to 6 is illustrated in Fig. 8. Fig. 8 schematically illustrates an example of a radio base station 800 (e.g. for a femtocell, a picocell, a microcell or a macrocell) comprising a sampling apparatus 820 as proposed.

A receiver 810 of the base station 800 comprises the sampling apparatus 820. The receiver 810 additionally comprises analog circuitry 830 configured to receive an RF receive signal from at least one antenna element 850 of the base station 800. The analog circuitry 830 is further configured to supply the input signal to the input node of the sampling apparatus 820 based on the RF receive signal. The sampling apparatus 820 samples the input signal. The sampling apparatus 820 may, e.g., be an ADC configured to generate a digital output signal based on a charge state of the sampling capacitor of the sampling apparatus 820. For example, the analog circuitry 830 may be an analog RF front-end and comprising one or more of a Low-Noise Amplifier (LNA), a filter, a down-conversion mixer, ElectroStatic Discharge (ESD) protection circuitry, an attenuator etc. The analog circuitry 830 may additionally or alternatively comprise an input buffer coupled to the input node of the sampling apparatus 820. The input buffer may be configured to supply the input signal to the input node of the sampling apparatus 820.

Further, the base station 800 comprises a transmitter 840 configured to generate an RF transmit signal. The transmitter 840 may use the antenna element 850 or another antenna element (not illustrated) of the base station 800 for radiating the RF transmit signal to the environment.

To this end, a base station with improved sampling capabilities may be provided may be provided.

The base station 800 may comprise further elements such as, e.g., an application processor, memory, a network controller, a user interface, power management circuitry, a satellite navigation receiver, a network interface controller or power tee circuitry.

In some aspects, the application processor may include one or more Central Processing Unit CPU cores and one or more of cache memory, a Low-DropOut (LDO) voltage regulator, interrupt controllers, serial interfaces such as Serial Peripheral Interface (SPI), Inter-Integrated Circuit (I²C) or universal programmable serial interface module, Real Time Clock (RTC), timer-counters including interval and watchdog timers, general purpose Input-Output (IO), memory card controllers such as Secure Digital (SD)/ MultiMedia Card (MMC) or similar, Universal Serial Bus (USB) interfaces, Mobile Industry Processor Interface Alliance (MIPI) interfaces and Joint Test Access Group (JTAG) test access ports.

In some aspects, the baseband processor may be implemented, for example, as a solder-down substrate including one or more integrated circuits, a single packaged integrated circuit soldered to a main circuit board or a multi-chip module containing two or more integrated circuits.

In some aspects, the memory may include one or more of volatile memory including Dynamic Random Access Memory (DRAM) and/or Synchronous Dynamic Random Access Memory (SDRAM), and Non-Volatile Memory (NVM) including high-speed electrically erasable memory (commonly referred to as Flash memory), Phase change Random Access Memory (PRAM), Magnetoresistive Random Access Memory (MRAM) and/or a three-dimensional crosspoint (3D XPoint) memory. The memory may be implemented as one or more of solder down packaged integrated circuits, socketed memory modules and plug-in memory cards.

In some aspects, the power management integrated circuitry may include one or more of voltage regulators, surge protectors, power alarm detection circuitry and one or more backup power sources such as a battery or capacitor. Power alarm detection circuitry may detect one or more of brown out (under-voltage) and surge (over-voltage) conditions.

In some aspects, the power tee circuitry may provide for electrical power drawn from a network cable to provide both power supply and data connectivity to the base station using a single cable.

In some aspects, the network controller may provide connectivity to a network using a standard network interface protocol such as Ethernet. Network connectivity may be provided using a physical connection which is one of electrical (commonly referred to as copper interconnect), optical or wireless.

In some aspects, the satellite navigation receiver module may include circuitry to receive and decode signals transmitted by one or more navigation satellite constellations such as the Global Positioning System (GPS), GLObalnaya NAvigatSionnaya Sputnikovaya Sistema (GLONASS), Galileo and/or BeiDou. The receiver may provide data to the application processor which may include one or more of position data or time data. The application processor may use time data to synchronize operations with other radio base stations.

In some aspects, the user interface may include one or more of physical or virtual buttons, such as a reset button, one or more indicators such as Light Emitting Diodes (LEDs) and a display screen.

Another example of an implementation using bootstrapping according to one or more aspects of the architecture described above in connection with Figs. 1 to 6 or one or more examples described above in connection with Figs. 1 to 6 is illustrated in Fig. 9. Fig. 9 schematically illustrates an example of a mobile device 900 (e.g. mobile phone, smartphone, tablet-computer, or laptop) comprising a sampling apparatus 920 as proposed.

A receiver 910 of the mobile device 900 comprises the sampling apparatus 920. The receiver 910 additionally comprises analog circuitry 930 configured to receive an RF receive signal from at least one antenna element 950 of the mobile device 900. The analog circuitry 930 is further configured to supply the input signal to the input node of the sampling apparatus 920 based on the RF receive signal. The sampling apparatus 920 samples the input signal. The sampling apparatus 920 may, e.g., be an ADC configured to generate a digital output signal based on a charge state of the sampling capacitor of the sampling apparatus 920. For example, the analog circuitry 930 may be an analog RF front-end and comprising one or more of a LNA, a filter, a down-conversion mixer, ESD protection circuitry, an attenuator etc. The analog circuitry 930 may additionally or alternatively comprise an input buffer coupled to the input node of the sampling apparatus 920. The input buffer may be configured to supply the input signal to the input node of the sampling apparatus 920.

Further, the mobile device 900 comprises a transmitter 940 configured to generate an RF transmit signal. The transmitter 940 may use the antenna element 950 or another antenna element (not illustrated) of the mobile device 900 for radiating the RF transmit signal to the environment.

To this end, a mobile device with improved sampling capabilities may be provided.

The mobile device 900 may comprise further elements such as, e.g., a baseband processor, memory, a connectivity module, a Near Field Communication (NFC) controller, an audio driver, a camera driver, a touch screen, a display driver, sensors, removable memory, a power management integrated circuit or a smart battery.

In some aspects, the application processor may include, for example, one or more CPU cores and one or more of cache memory, LDO regulators, interrupt controllers, serial interfaces such as SPI, I²C or universal programmable serial interface module, RTC, timer-counters including interval and watchdog timers, general purpose input-output (IO), memory card controllers such as SD/MMC or similar, USB interfaces, MIPI interfaces and JTAG test access ports.

In some aspects, the baseband module may be implemented, for example, as a solder-down substrate including one or more integrated circuits, a single packaged integrated circuit soldered to a main circuit board, and/or a multi-chip module containing two or more integrated circuits.

The wireless communication circuits using bootstrapping according to the proposed architecture or one or more of the examples described above may be configured to operate according to one of the 3rd Generation Partnership Project (3GPP)-standardized mobile communication networks or systems. The mobile or wireless communication system may correspond to, for example, a 5^{th} Generation New Radio (5G NR), a Long-Term Evolution (LTE), an LTE-Advanced (LTE-A), High Speed Packet Access (HSPA), a Universal Mobile Telecommunication System (UMTS) or a UMTS Terrestrial Radio Access Network (UTRAN), an evolved-UTRAN (e-UTRAN), a Global System for Mobile communication (GSM), an Enhanced Data rates for GSM Evolution (EDGE) network, or a GSM/EDGE Radio Access Network (GERAN). Alternatively, the wireless communication circuits may be configured to operate according to mobile communication networks with different standards, for example, a Worldwide Inter-operability for Microwave Access (WIMAX) network IEEE 802.16 or Wireless Local Area Network (WLAN) IEEE 802.11, generally an Orthogonal Frequency Division Multiple Access (OFDMA) network, a Time Division Multiple Access (TDMA) network, a Code Division Multiple Access (CDMA) network, a Wideband-CDMA (WCDMA) network, a Frequency Division Multiple Access (FDMA) network, a Spatial Division Multiple Access (SDMA) network, etc.

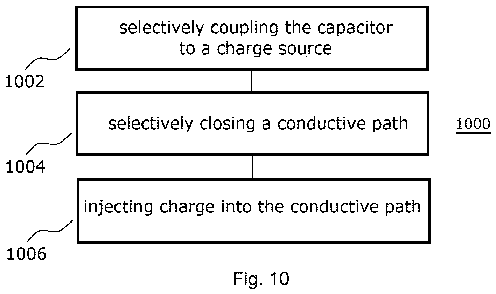

For further illustrating the bootstrapping described above, Fig. 10 illustrates a flowchart of method 1000 of operating a bootstrapping circuit for a semiconductor switch. The bootstrapping circuit comprises a capacitor, a first node for coupling to an input node of the semiconductor switch and a second node for coupling to a control node of the semiconductor switch. The method 1000 comprises selectively coupling 1002 the capacitor to a charge source by a switch circuit of the bootstrapping circuit while the semiconductor switch is open. Further, the method 1000 comprises selectively closing 1004 a conductive path between the first node and the second node by the switch circuit for closing the semiconductor switch. The conductive path includes the capacitor. Additionally, the method 1000 comprises injecting 1006 charge into the conductive path by charge injection circuitry of the bootstrapping circuit before, while or after the conductive path is closed by the switch circuit. The method 1000 may allow to charge the parasitic capacitances of the bootstrapping circuit by means of the additional charge injected by the charge injection circuitry such that a smaller current peak is drawn from circuitry preceding the bootstrapping circuit and the semiconductor switch.

More details and aspects of the method 1000 are explained in connection with the proposed technique or one or more examples described above (e.g. Figs. 1 to 6). The method 1000 may comprise one or more additional optional features corresponding to one or more aspects of the proposed technique or one or more examples described above.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example.

## Claims

1. A bootstrapping circuit (100) for a semiconductor switch (180), the bootstrapping circuit (100) comprising:
a capacitor (110);
a first node (120) for coupling to an input node (181) of the semiconductor switch (180);
a second node (130) for coupling to a control node (182) of the semiconductor switch (180);
a switch circuit configured to selectively couple the capacitor (110) to a charge source (150, 200, 300, 400) while the semiconductor switch (180) is open and to selectively close a conductive path (170) between the first node (120) and the second node (130) for closing the semiconductor switch (180), wherein the conductive path (170) includes the capacitor (110), wherein the switch circuit is further configured to decouple the capacitor (110) from the first node (120) and the second node (130) while the capacitor (110) is coupled to the charge source (150, 200, 300, 400) by the switch circuit, and wherein the switch circuit is further configured to selectively couple the second node (130) to a third node (190) for opening the semiconductor switch (180), wherein the third node (190) is configured to receive a reference voltage signal; and
charge injection circuitry (160) configured to inject charge into the conductive path (170) at the first node (120) before, while or after the conductive path (170) is closed by the switch circuit.

2. The bootstrapping circuit (100) of claim 1, wherein the switch circuit is further configured to decouple the capacitor (110) from the charge source (150, 200, 300, 400) before the conductive path (170) is closed by the switch circuit.

3. The bootstrapping circuit (100) of claim 1 or claim 2, wherein the switch circuit comprises a first switch (141) coupled between the capacitor (110) and the first node (120) for selectively closing the conductive path (170).

4. The bootstrapping circuit (100) of any one of claims 1 to 3, wherein the switch circuit comprises a second switch (142) coupled between the capacitor (110) and the second node (130) for selectively closing the conductive path (170).

5. The bootstrapping circuit (100) of any one of claims 1 to 4, wherein the charge source (150, 200, 300, 400) comprises a fourth node (151) configured to receive a first voltage supply signal and a fifth node (152) configured to receive a second voltage supply signal, wherein the switch circuit comprises a third switch (143) for selectively coupling the capacitor (110) to the fourth node (151) and a fourth switch (144) for selectively coupling the capacitor (110) to the fifth node (152).

6. The bootstrapping circuit (100) of any one of claims 1 to 5, wherein the charge injection circuitry (200) comprises:
a sixth node (210) configured to receive a first voltage supply signal;
a pulse generator (220) configured to selectively generate a pulse (221) based on a control signal (201); and
a switch (230) configured to selectively couple the sixth node (210) with the conductive path (170) upon reception of the pulse (221).

7. The bootstrapping circuit (100) of any one of claims 1 to 5, wherein the charge injection circuitry (300) comprises:
a current source (310) configured to generate a current signal;
a pulse generator (320) configured to selectively generate a pulse (321) based on a control signal (301); and
a switch (330) configured to selectively couple the current source (310) with the conductive path (170) upon reception of the pulse (321).

8. The bootstrapping circuit (100) of any one of claims 1 to 5, wherein the charge injection circuitry (400) comprises:
one or more buffer capacitors (410) ;
a plurality of switches (431, ..., 435); and
a control circuit (420) configured to control, based on a control signal (401), the plurality of switches (431, ..., 435) to selectively couple one or more of the one or more buffer capacitors (410) to nodes configured to receive a respective one of a first voltage supply signal and a second voltage supply signal for charging one or more of the one or more buffer capacitors (410), wherein the control circuit (420) is further configured to control, based on the control signal (401), the plurality of switches (431, ..., 435) to selectively couple one or more of the one or more buffer capacitors (410) to the conductive path (170).

9. A method (1000) of operating a bootstrapping circuit for a semiconductor switch, the bootstrapping circuit comprising a capacitor, a first node for coupling to an input node of the semiconductor switch and a second node for coupling to a control node of the semiconductor switch, the method comprising:
selectively coupling (1002) the capacitor to a charge source by a switch circuit of the bootstrapping circuit while the semiconductor switch is open;
selectively closing (1004) a conductive path between the first node and the second node by the switch circuit for closing the semiconductor switch, wherein the conductive path includes the capacitor;
injecting (1006) charge into the conductive path at the first node by charge injection circuitry of the bootstrapping circuit before, while or after the conductive path is closed by the switch circuit;
decoupling the capacitor from the first node and the second node while the capacitor is coupled to the charge source by the switch circuit; and
selectively coupling the second node to a fifth node for opening the semiconductor switch, wherein the fifth node is configured to receive a reference voltage signal.

10. The method (1000) of claim 9, further comprising:
decoupling the capacitor (110) from the charge source (150, 200, 300, 400) before the conductive path is closed by the switch circuit.

11. A sampling apparatus (500), comprising:
an input node (510) configured to receive an input signal (501);
a sampling capacitor (520);
a semiconductor switch (530) coupled between the input node (510) and the sampling capacitor (520), wherein the semiconductor switch (530) is configured to selectively couple the sampling capacitor (520) to the input node (510); and
a bootstrapping circuit (100) according to any of claims 1 to 10 for controlling the semiconductor switch (530), wherein the first node (120) of the bootstrapping circuit (100) is coupled to the input node (510) of the sampling apparatus (500) and an input node (531) of the semiconductor switch (530), and wherein the second node (130) of the bootstrapping circuit (100) is coupled to a control node (532) of the semiconductor switch (530).

12. The sampling apparatus (500) of claim 11, wherein the sampling apparatus (500) is an analog-to-digital converter configured to generate a digital output signal based on a charge state of the sampling capacitor (520).

13. A receiver (810, 910) comprising:
a sampling apparatus (820, 920) according to claim 11 or claim 12; and
analog circuitry (830, 930) configured to receive a radio frequency receive signal from an antenna element (850, 950), and to supply the input signal to the input node of the sampling apparatus (820, 920) based on the radio frequency receive signal.

14. The receiver (800, 900) of claim 13, wherein the analog circuitry (830, 930) comprises an input buffer (540) coupled to the input node of the sampling apparatus (820, 920) and configured to supply the input signal to the input node of the sampling apparatus (820, 920).

15. A base station (800), comprising:
a receiver (810) according to claim 13 or claim 14; and
a transmitter (840) configured to generate a radio frequency transmit signal.

## Patentansprüche

1. Bootstrapping-Schaltung (100) für einen Halbleiterschalter (180), wobei die Bootstrapping-Schaltung (100) Folgendes umfasst:
einen Kondensator (110);
einen ersten Knoten (120) zum Koppeln an einen Eingangsknoten (181) des Halbleiterschalters (180);
einen zweiten Knoten (130) zum Koppeln an einen Steuerknoten (182) des Halbleiterschalters (180);
eine Schalterschaltung, die dazu ausgelegt ist, den Kondensator (110) selektiv an eine Ladequelle (150, 200, 300, 400) zu koppeln, während der Halbleiterschalter (180) geöffnet ist, und selektiv einen Leiterbahn (170) zwischen dem ersten Knoten (120) und dem zweiten Knoten (130) zum Schließen des Halbleiterschalters (180) zu schließen, wobei die Leiterbahn (170) den Kondensator (110) beinhaltet, wobei die Schalterschaltung ferner dazu ausgelegt ist, den Kondensator (110) von dem ersten Knoten (120) und dem zweiten Knoten (130) zu entkoppeln, während der Kondensator (110) durch die Schalterschaltung mit der Ladungsquelle (150, 200, 300, 400) durch die Schalterschaltung gekoppelt ist, und wobei die Schalterschaltung ferner dazu ausgelegt ist, den zweiten Knoten (130) selektiv mit einem dritten Knoten (190) zu koppeln, um den Halbleiterschalter (180) zu öffnen, wobei der dritte Knoten (190) dazu ausgelegt ist, ein Referenzspannungssignal zu empfangen; und
eine Ladungseinspeiseschaltungsanordnung (160), die dazu ausgelegt ist, Ladung in die Leiterbahn (170) am ersten Knoten (120) einzuspeisen, bevor, während oder nachdem die Leiterbahn (170) durch die Schalterschaltung geschlossen wird.

2. Bootstrapping-Schaltung (100) nach Anspruch 1, wobei die Schalterschaltung ferner dazu ausgelegt ist, den Kondensator (110) von der Ladungsquelle (150, 200, 300, 400) zu entkoppeln, bevor die Leiterbahn (170) durch die Schalterschaltung geschlossen wird.

3. Bootstrapping-Schaltung (100) nach Anspruch 1 oder Anspruch 2, wobei die Schalterschaltung einen ersten Schalter (141) umfasst, der zwischen dem Kondensator (110) und dem ersten Knoten (120) zum selektiven Schließen der Leiterbahn (170) gekoppelt ist.

4. Bootstrapping-Schaltung (100) nach einem der Ansprüche 1 bis 3, wobei die Schalterschaltung einen zweiten Schalter (142) umfasst, der zwischen dem Kondensator (110) und dem zweiten Knoten (130) zum selektiven Schließen der Leiterbahn (170) gekoppelt ist.

5. Bootstrapping-Schaltung (100) nach einem der Ansprüche 1 bis 4, wobei die Ladungsquelle (150, 200, 300, 400) einen vierten Knoten (151), der dazu ausgelegt ist, ein erstes Spannungsversorgungssignal zu empfangen, und einen fünften Knoten (152) umfasst, der dazu ausgelegt ist, ein zweites Spannungsversorgungssignal zu empfangen, wobei die Schalterschaltung einen dritten Schalter (143) zum selektiven Koppeln des Kondensators (110) mit dem vierten Knoten (151) und einen vierten Schalter (144) zum selektiven Koppeln des Kondensators (110) mit dem fünften Knoten (152) umfasst.

6. Bootstrapping-Schaltung (100) nach einem der Ansprüche 1 bis 5, wobei die Ladungseinspeiseschaltungsanordnung (200) Folgendes umfasst:
ein sechster Knoten (210), der dazu ausgelegt ist, ein erstes Spannungsversorgungssignal zu empfangen;
einen Impulsgenerator (220), der dazu ausgelegt ist, selektiv einen Impuls (221) basierend auf einem Steuersignal (201) zu erzeugen; und
einen Schalter (230), der dazu ausgelegt ist, den sechsten Knoten (210) selektiv bei Empfang des Impulses (221) mit der Leiterbahn (170) zu koppeln.

7. Bootstrapping-Schaltung (100) nach einem der Ansprüche 1 bis 5, wobei die Ladungseinspeiseschaltungsanordnung (300) Folgendes umfasst:
eine Stromquelle (310), die dazu ausgelegt ist, ein Stromsignal zu erzeugen;
einen Impulsgenerator (320), der dazu ausgelegt ist, selektiv einen Impuls (321) basierend auf einem Steuersignal (301) zu erzeugen; und
einen Schalter (330), der dazu ausgelegt ist, die Stromquelle (310) selektiv bei Empfang des Impulses (321) mit der Leiterbahn (170) zu koppeln.

8. Bootstrapping-Schaltung (100) nach einem der Ansprüche 1 bis 5, wobei die Ladungseinspeiseschaltungsanordnung (400) Folgendes umfasst:
einen oder mehrere Pufferkondensatoren (410);
eine Mehrzahl von Schaltern (431, ..., 435); und
eine Steuerschaltung (420), die dazu ausgelegt ist, basierend auf einem Steuersignal (401) die Mehrzahl von Schaltern (431, ..., 435) zu steuern, um einen oder mehrere der einen oder mehreren Pufferkondensatoren (410) selektiv mit Knoten zu koppeln, die dazu ausgelegt sind, ein jeweiliges eines ersten Spannungsversorgungssignals und eines zweiten Spannungsversorgungssignals zum Laden eines oder mehrerer des einen oder mehrerer Pufferkondensatoren (410) zu laden, wobei die Steuerschaltung (420) ferner dazu ausgelegt ist, basierend auf dem Steuersignal (401) die Mehrzahl von Schaltern (431, ..., 435) zu steuern, um einen oder mehrere des einen oder mehrerer Pufferkondensatoren (410) selektiv mit der Leiterbahn (170) zu koppeln.

9. Verfahren (1000) zum Betreiben einer Bootstrapping-Schaltung für einen Halbleiterschalter, wobei die Bootstrapping-Schaltung einen Kondensator, einen ersten Knoten zum Koppeln an einen Eingangsknoten des Halbleiterschalters und einen zweiten Knoten zum Koppeln an einen Steuerknoten des Halbleiterschalters umfasst, wobei das Verfahren Folgendes umfasst:
selektives Koppeln (1002) des Kondensators an eine Ladequelle durch eine Schalterschaltung der Bootstrapping-Schaltung, während der Halbleiterschalter geöffnet ist;
selektives Schließen (1004) einer Leiterbahn zwischen dem ersten Knoten und dem zweiten Knoten durch die Schalterschaltung zum Schließen des Halbleiterschalters, wobei die Leiterbahn den Kondensator beinhaltet;
Einspeisen (1006) von Ladung in die Leiterbahn am ersten Knoten durch eine Ladungseinspeiseschaltungsanordnung der Bootstrapping-Schaltung, bevor, während oder nachdem die Leiterbahn durch die Schalterschaltung geschlossen wird;
Entkoppeln des Kondensator von dem ersten Knoten und dem zweiten Knoten, während der Kondensator durch die Schalterschaltung mit der Ladungsquelle gekoppelt ist; und
selektives Koppeln des zweiten Knotens mit einem fünften Knoten zum Öffnen des Halbleiterschalters, wobei der fünfte Knoten dazu ausgelegt ist, ein Referenzspannungssignal zu empfangen.

10. Verfahren (1000) nach Anspruch 9, das ferner Folgendes umfassend:
Entkoppeln des Kondensators (110) von der Ladungsquelle (150, 200, 300, 400), bevor die Leiterbahn durch die Schalterschaltung geschlossen wird.

11. Abtastvorrichtung (500), die Folgendes umfasst:
einen Eingangsknoten (510), der dazu ausgelegt ist, ein Eingangssignal (501) zu empfangen;
einen Abtastkondensator (520);
einen Halbleiterschalter (530), der zwischen dem Eingangsknoten (510) und dem Abtastkondensator (520) gekoppelt ist, wobei der Halbleiterschalter (530) dazu ausgelegt ist, den Abtastkondensator (520) selektiv mit dem Eingangsknoten (510) zu koppeln; und
eine Bootstrapping-Schaltung (100) nach einem der Ansprüche 1 bis 10 zum Steuern des Halbleiterschalters (530), wobei der erste Knoten (120) der Bootstrapping-Schaltung (100) mit dem Eingangsknoten (510) der Abtastvorrichtung (500) und einem Eingangsknoten (531) des Halbleiterschalters (530) gekoppelt ist, und wobei der zweite Knoten (130) der Bootstrapping-Schaltung (100) mit einem Steuerknoten (532) des Halbleiterschalters (530) gekoppelt ist.

12. Abtastvorrichtung (500) nach Anspruch 11, wobei die Abtastvorrichtung (500) ein Analog-Digital-Umsetzer ist, der dazu ausgelegt ist, ein digitales Ausgangssignal basierend auf einem Ladezustand des Abtastkondensators (520) zu erzeugen.

13. Empfänger (810, 910), der Folgendes umfasst:
eine Abtastvorrichtung (820, 920) nach Anspruch 11 oder Anspruch 12; und
eine Analogschaltungsanordnung (830, 930), der dazu ausgelegt ist, ein Hochfrequenz-Empfangssignal von einem Antennenelement (850, 950) zu empfangen und das Eingangssignal basierend auf dem Hochfrequenz-Empfangssignal an den Eingangsknoten der Abtastvorrichtung (820, 920) zu liefern.

14. Empfänger (800, 900) nach Anspruch 13, wobei die Analogschaltungsanordnung (830, 930) einen Eingangspuffer (540) umfasst, der mit dem Eingangsknoten der Abtastvorrichtung (820, 920) gekoppelt und dazu ausgelegt ist, das Eingangssignal an den Eingangsknoten der Abtastvorrichtung (820, 920) zu liefern.

15. Basisstation (800), die Folgendes umfasst:
einen Empfänger (810) nach Anspruch 13 oder Anspruch 14; und
einen Sender (840), der dazu ausgelegt ist, ein Hochfrequenz-Sendesignal zu erzeugen.

## Revendications

1. Circuit d'amorçage (100) pour un commutateur à semi-conducteur (180), le circuit d'amorçage (100) comprenant :
un condensateur (110) ;
un premier noeud (120) destiné à être couplé à un noeud d'entrée (181) du commutateur à semi-conducteur (180) ; un deuxième noeud (130) destiné à être couplé à un noeud de commande (182) du commutateur à semi-conducteur (180) ;
un circuit de commutation configuré pour coupler sélectivement le condensateur (110) à une source de charge (150, 200, 300, 400) lorsque le commutateur à semi-conducteur (180) est ouvert et pour fermer sélectivement un chemin conducteur (170) entre le premier noeud (120) et le deuxième noeud (130) pour fermer le commutateur à semi-conducteur (180), le chemin conducteur (170) comportant le condensateur (110), le circuit de commutation étant en outre configuré pour découpler le condensateur (110) du premier noeud (120) et du deuxième noeud (130) tandis que le condensateur (110) est couplé à la source de charge (150, 200, 300, 400) par le circuit de commutation, et le circuit de commutation étant en outre configuré pour coupler sélectivement le deuxième noeud (130) à un troisième noeud (190) pour ouvrir le commutateur à semi-conducteur (180), le troisième noeud (190) étant configuré pour recevoir un signal de tension de référence ; et
une circuiterie d'injection de charge (160) configurée pour injecter une charge dans le chemin conducteur (170) au niveau du premier noeud (120) avant, pendant ou après la fermeture du chemin conducteur (170) par le circuit de commutation.

2. Circuit d'amorçage (100) selon la revendication 1, dans lequel le circuit de commutation est en outre configuré pour découpler le condensateur (110) de la source de charge (150, 200, 300, 400) avant la fermeture du chemin conducteur (170) par le circuit de commutation.

3. Circuit d'amorçage (100) selon la revendication 1 ou la revendication 2, dans lequel le circuit de commutation comprend un premier commutateur (141) couplé entre le condensateur (110) et le premier noeud (120) pour fermer sélectivement le chemin conducteur (170).

4. Circuit d'amorçage (100) selon l'une quelconque des revendications 1 à 3, dans lequel le circuit de commutation comprend un deuxième commutateur (142) couplé entre le condensateur (110) et le deuxième noeud (130) pour fermer sélectivement le chemin conducteur (170).

5. Circuit d'amorçage (100) selon l'une quelconque des revendications 1 à 4, dans lequel la source de charge (150, 200, 300, 400) comprend un quatrième noeud (151) configuré pour recevoir un premier signal d'alimentation en tension et un cinquième noeud (152) configuré pour recevoir un deuxième signal d'alimentation en tension, le circuit de commutation comprenant un troisième commutateur (143) pour coupler sélectivement le condensateur (110) au quatrième noeud (151) et un quatrième commutateur (144) pour coupler sélectivement le condensateur (110) au cinquième noeud (152).

6. Circuit d'amorçage (100) selon l'une quelconque des revendications 1 à 5, dans lequel la circuiterie d'injection de charge (200) comprend :
un sixième noeud (210) configuré pour recevoir un premier signal d'alimentation en tension ;
un générateur d'impulsions (220) configuré pour générer sélectivement une impulsion (221) sur la base d'un signal de commande (201) ; et
un commutateur (230) configuré pour coupler sélectivement le sixième noeud (210) au chemin conducteur (170) lors de la réception de l'impulsion (221).

7. Circuit d'amorçage (100) selon l'une quelconque des revendications 1 à 5, dans lequel la circuiterie d'injection de charge (300) comprend :
une source de courant (310) configurée pour générer un signal de courant ;
un générateur d'impulsions (320) configuré pour générer sélectivement une impulsion (321) sur la base d'un signal de commande (301) ; et
un commutateur (330) configuré pour coupler sélectivement la source de courant (310) au chemin conducteur (170) lors de la réception de l'impulsion (321).

8. Circuit d'amorçage (100) selon l'une quelconque des revendications 1 à 5, dans lequel la circuiterie d'injection de charge (400) comprend :
un ou plusieurs condensateurs tampons (410) ;
une pluralité de commutateurs (431, ..., 435) ; et
un circuit de commande (420) configuré pour commander, sur la base d'un signal de commande (401), la pluralité de commutateurs (431, ..., 435) pour coupler sélectivement un ou plusieurs des un ou plusieurs condensateurs tampons (410) à des noeuds configurés pour recevoir un signal respectif parmi un premier signal d'alimentation en tension et un deuxième signal d'alimentation en tension pour charger un ou plusieurs des un ou plusieurs condensateurs tampons (410), le circuit de commande (420) étant en outre configuré pour commander, sur la base du signal de commande (401), la pluralité de commutateurs (431, ..., 435) pour coupler sélectivement un ou plusieurs des un ou plusieurs condensateurs tampons (410) au chemin conducteur (170).

9. Procédé (1000) de fonctionnement d'un circuit d'amorçage pour un commutateur à semi-conducteur, le circuit d'amorçage comprenant un condensateur, un premier noeud destiné à être couplé à un noeud d'entrée du commutateur à semi-conducteur et un deuxième noeud destiné à être couplé à un noeud de commande du commutateur à semi-conducteur, le procédé comprenant :
le couplage sélectif (1002) du condensateur à une source de charge par un circuit de commutation du circuit d'amorçage lorsque le commutateur à semi-conducteur est ouvert ;
la fermeture sélective (1004) d'un chemin conducteur entre le premier noeud et le deuxième noeud par le circuit de commutation pour fermer le commutateur à semi-conducteur, le chemin conducteur comportant le condensateur ;
l'injection (1006) d'une charge dans le chemin conducteur au niveau du premier noeud par une circuiterie d'injection de charge du circuit d'amorçage avant, pendant ou après la fermeture du chemin conducteur par le circuit de commutation ;
le découplage du condensateur du premier noeud et du deuxième noeud tandis que le condensateur est couplé à la source de charge par le circuit de commutation ; et
le couplage sélectif du deuxième noeud à un cinquième noeud pour ouvrir le commutateur à semi-conducteur, le cinquième noeud étant configuré pour recevoir un signal de tension de référence.

10. Procédé (1000) selon la revendication 9, comprenant en outre :
le découplage du condensateur (110) de la source de charge (150, 200, 300, 400) avant la fermeture du chemin conducteur par le circuit de commutation.

11. Appareil d'échantillonnage (500), comprenant :
un noeud d'entrée (510) configuré pour recevoir un signal d'entrée (501) ;
un condensateur d'échantillonnage (520) ;
un commutateur à semi-conducteur (530) couplé entre le noeud d'entrée (510) et le condensateur d'échantillonnage (520), le commutateur à semi-conducteur (530) étant configuré pour coupler sélectivement le condensateur d'échantillonnage (520) au noeud d'entrée (510) ; et
un circuit d'amorçage (100) selon l'une quelconque des revendications 1 à 10 pour commander le commutateur à semi-conducteur (530), le premier noeud (120) du circuit d'amorçage (100) étant couplé au noeud d'entrée (510) de l'appareil d'échantillonnage (500) et à un noeud d'entrée (531) du commutateur à semi-conducteur (530), et le deuxième noeud (130) du circuit d'amorçage (100) étant couplé à un noeud de commande (532) du commutateur à semi-conducteur (530).

12. Appareil d'échantillonnage (500) selon la revendication 11, dans lequel l'appareil d'échantillonnage (500) est un convertisseur analogique-numérique configuré pour générer un signal de sortie numérique sur la base d'un état de charge du condensateur d'échantillonnage (520).

13. Récepteur (810, 910) comprenant :
un appareil d'échantillonnage (820, 920) selon la revendication 11 ou la revendication 12 ; et
une circuiterie analogique (830, 930) configurée pour recevoir un signal de réception radiofréquence provenant d'un élément antenne (850, 950), et pour fournir le signal d'entrée au noeud d'entrée de l'appareil d'échantillonnage (820, 920) sur la base du signal de réception radiofréquence.

14. Récepteur (800, 900) selon la revendication 13, dans lequel la circuiterie analogique (830, 930) comprend un tampon d'entrée (540) couplé au noeud d'entrée de l'appareil d'échantillonnage (820, 920) et configuré pour fournir le signal d'entrée au noeud d'entrée de l'appareil d'échantillonnage (820, 920).

15. Station de base (800), comprenant :
un récepteur (810) selon la revendication 13 ou la revendication 14 ; et
un émetteur (840) configuré pour générer un signal d'émission radiofréquence.
